Europäisches Patentamt

European Patent Office

Office européen des brevets

(11) Publication number: **0 130 416**
**B1**

## EUROPEAN PATENT SPECIFICATION

(45) Date of publication of patent specification: **12.10.88**

(51) Int. Cl.⁴: **H 01 L 21/285,** H 01 L 21/40

(21) Application number: **84106538.6**

(22) Date of filing: **08.06.84**

(54) **A process for making an ohmic contact to an N-type conductivity group III-V semiconductor compound and a semiconductor device having such an ohmic contact.**

(30) Priority: **30.06.83 US 509732**

(43) Date of publication of application:
**09.01.85 Bulletin 85/02**

(45) Publication of the grant of the patent:
**12.10.88 Bulletin 88/41**

(84) Designated Contracting States:
**DE FR GB**

(56) References cited:
**US-A- 439 896**
**US-A-3 987 480**
**US-A-4 011 583**
**US-A-4 188 710**

**IEEE JOURNAL OF SOLID-STATE CIRCUITS,
vol. SC-13, no. 4, August 1978, New York, USA;
W.T. ANDERSON et al. "Development of Ohmic
Contacts for GaAs Devices Using Epitaxial GE
Films", pages 430-435**

**IEEE TRANSACTIONS ON ELECTRON
DEVICES, vol. ED-22, no. 5, May 1975, New
York, USA; A.K. SINHA et al. "Sintered Ohmic
Contacts to n- and p-Type GaAS", pages
218-224**

(73) Proprietor: **International Business Machines
Corporation
Old Orchard Road
Armonk, N.Y. 10504 (US)**

(72) Inventor: **Rupprecht, Hans Stephan
3505 Kamhi Drive
Yorktown Heights New York 10598 (US)**
Inventor: **Tiwari, Sandip
791 Pinesbridge Road
Ossining New York 10562 (US)**

(74) Representative: **Hobbs, Francis John
IBM United Kingdom Limited Intellectual
Property Department Hursley Park
Winchester Hampshire SO21 2JN (GB)**

(56) References cited:
**IEEE ELECTRON DEVICES LETTERS, vol. 2, no.
5, May 1981, New York, USA; W.T. ANDERSON
et al. "Laser annealed Ta/Ge and Ni/Ge Ohmic
Contacts to GaAs", pages 115-117**

EP 0 130 416 B1

Courier Press, Leamington Spa, England.

## Description

This invention relates to a process for making an ohmic contact to an n-type conductivity group III—V semiconductor compound and a semiconductor device having such an ohmic contact.

In the fabrication of semiconductor devices, one of the more esoteric problems which arises is in providing a contact to a semiconductor substrate which is compatible with both the substrate and the metallurgy which interconnects with other contacts on the same substrate. This is no simple matter in view of the fact that factors like the kind of semiconductor, the doping of the semiconductor and the type of metals involved may influence whether the resulting contact is ohmic or rectifying.

US—A—3,987,480 discloses a group III—V semiconductor substrate with an ohmic contact to a high resistivity region. Two metals such as tantalum and germanium are vapour deposited together on the substrate and the structure is then heated between 350° and 650°C in a neutral or reducing atmosphere for 10 to 40 minutes. Under these circumstances, a germanide of tantalum is not formed because of the temperature used.

US—A—3,965,279 discloses a process for forming an ohmic contact to an n-type Group III—V semiconductor in which germanium and palladium are deposited on the semiconductor either in the form of an alloy or discrete layers. The resulting structure is heated for five minutes to two hours at a temperature in the range of 200 to 700°C. The reference suggests that palladium rich compounds such as $Pd_2Ge$ are formed. Palladium is not, however, a refractory metal and the resulting ohmic contact has a relatively high contact resistance.

US—A—4,188,710 discloses a gallium arsenide substrate on which a layer of epitaxial germanium is formed and then a layer of tungsten, tantalum or molybdenum is formed over the germanium layer. The structure is annealed at a temperature of 400°C to 500°C for thirty minutes. In this reference, no germanide layer is formed in view of the annealing temperatures used. Using the technique of the patent, contact resistance of the order of $10^{-4}$ ohm $cm^2$ are obtainable as opposed to the contact resistance of contacts made in accordance with the teaching of the present invention which are approximately two orders of magnitude better.

An article in IEEE Journal of Solid State Circuits, Vol. SC-13, No. 4, August 1978, pages 430 to 435 mentions a process for forming an ohmic contact to a substrate of a semiconductor compound comprising a Group III element and a Group V element and containing an n-type dopant, comprising the steps of vapour depositing germanium and molybdenum or tantalum onto a surface of the substrate, and heating the substrate in a vacuum or a nonoxidising atmosphere. The process disclosed in that prior document produces a contact having a resistance of no lower than $5 \times 10^{-4}$ ohm $cm^2$.

The invention seeks to provide an improved ohmic contact to n-type conductivity semiconductor compounds comprising a Group III element and a Group V element.

In accordance with one aspect of the invention, a process for forming an ohmic contact to a substrate of a semiconductor compound comprising a Group III element and a Group V element and containing an n-type dopant, comprises the steps of vapour depositing germanium and molybdenum onto a surface of the substrate, and heating the substrate in a nonoxidising atmosphere, the process being characterised by heating the substrate for seven minutes at a temperature in the range of 725 to 775°C in order to form a layer of molybdenum germanide ($MoGe_2$) and an interface layer not more than 10 nm thick of germanium heavily doped with the Group V element of the semiconductor compound.

According to another aspect of the invention, a semiconductor device comprises a substrate of an n-type conductivity semiconductor compound comprising a Group III element and a Group V element and having an ohmic contact comprising a region of the substrate doped with germanium and a layer of molybdenum germanide, the device being characterised by the contact having a resistance of $10^{-6}$ ohm $cm^2$ and by the presence of an interface region not more than 10 nm thick, of germanium heavily doped with the Group V element of said Group III—V compound disposed between the region doped with germanium and the molybdenum germanide layer.

How the invention can be carried out will now be described by way of example, with reference to the accompanying drawings, in which:—

Fig. 1 represents, in section, a semiconductor device structure before it is heated; and

Fig. 2 represents the semiconductor device structure of Fig. 1 after it has been heated.

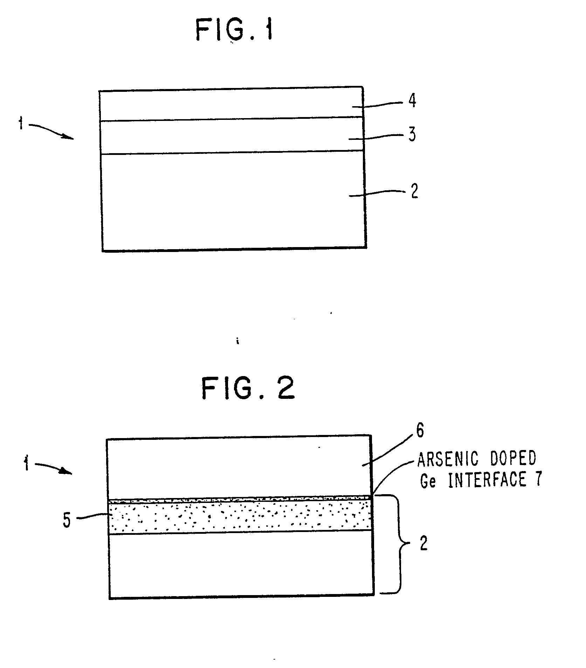

A semiconductor device 1 (Fig. 1) includes a substrate 2 of an n-doped III—V compound semiconductor material such as gallium arsenide. In a typical device, substrate 2 is doped with an n-type conductivity material such as silicon to a level of $1 \times 10^{17}$ atoms $cm^{-3}$. A layer 3 of germanium heavily doped with a n-type dopant such as arsenic is disposed on top of substrate 2. Alternatively, layer 3 may be undoped. Layer 4 which is disposed on top of layer 3 is a layer of molybdenum. At this point, it should be appreciated that layer 3 of germanium may be amorphous rather than single crystal in structure. If layer 3 is doped, it is doped to a level of $10^{20}$ atoms $cm^{-3}$ arsenic.

While the structure of Fig. 1 is shown as a plurality of layers, it should be appreciated that the germanium of layer 3 and the molybdenum of layer 4 may be vacuum deposited simultaneously from separate sources of germanium and molybdenum using apparatus and in a manner well-known to those skilled in the vacuum deposition arts.

Fig. 2 shows the structure of Fig. 1 after it is subjected to a sintering or annealing step at a temperature in the range of 700 to 800°C for 5 to 15 minutes in a nonoxidizing atmopshere. Hydrogen, a reducing gas, argon, a noble gas or nitrogen may be used. As a result of the heating step, a crosshatched region 5 of substrate 2 is doped with germanium and a molybdenum germanide layer 6 forms at the surface of substrate 2 and is spaced therefrom by a thin interface layer 7 of arsenic doped germanium. Layer 6 is of $MoGe_2$, which is the first-to-form germanide of molybdenum.

Using molybdenum for layer 4, sintering at a temperature of 725—775°C for a period of seven minutes provides the best results. In general, as has been indicated hereinabove, the sintering step should be carried out in a nonoxidizing atmosphere at a temperature and for a time sufficient to form the first-to-form germanide of molybdenum. Significantly, the temperatures at which this germanide forms does not permit the reaction of the refractory metal with either gallium or arsenic in the substrate. As a result, region 5 in substrate 2 is formed by the diffusion of germanium into the gallium arsenide of substrate 2. The diffusion is necessary to break through any oxide or contaminating region and to provide a uniform germanium contact represented by germanium interface layer 7 to the heavily germanium doped $n^+$ gallium arsenide substrate 2. The presence of region 5 also removes any conduction band edge discontinuity at the germanium/gallium arsenide interface by eliminating any abrupt metallurgical changes.

In order to produce a good ohmic contact to gallium arsenide, the following criteria should be met:

(i) after the high temperature sintering step, a germanium layer like germanium interface layer 7 in Fig. 2, however thin, should remain or become heavily doped n-type ($n \cong 5 \times 10^{19}$ atoms $cm^{-3}$);

(ii) at the end of the diffusion, germanium should have a high peak concentration at the germanium/gallium arsenide interface (this requires a high solubility limit of germanium in gallium arsenide); and

(iii) germanium should preferentially dope gallium arsenide n-type (germanium should therefore preferentially occupy.gallium sites in the gallium arsenide).

The formation of the molybdenum germanide layer 6 as shown in Fig. 2 as an integral part of the ohmic contact structure serves the following functions:

(a) it provides a high conductivity film for low resistance access to the contact (only a small area interconneccion need be provided to it to contact the ohmic area;

(b) it permits the out-diffusion of gallium instead of arsenic for preferential site occupation by germanium; gettering of gallium is not excessive; and

(c) it forms an acceptable barrier to any changes in the ohmic contact property which might occur as a result of metallurgical reaction with other contacting metals deposited on it.

In addition to the above, the molybdenum germanide of layer 6 has no or sufficiently small reactivity with excess germanium to allow the driving of germanium into gallium arsenide at the sintering temperature.

Finally, germanide layer 6 should have no or sufficiently small reactivity with arsenic to prevent any changes in the heavily doped n-type character of germanium. The resulting low reactivity of layer 6 and the presence of arsenic in germanium prevent any arsenic out-diffusion from gallium arsenide substrate 2. Since molybdenum has small electronegativity, it has very low reactivity with gallium and arsenic. The stable phase richest in germanium with the least solubility of excess germanium is realised in the formation of the first-to-form germanide of molybdenum, which is $MoGe_2$.

In a representative structure, substrate 2 has a thickness of 500 microns, region 5 has a depth of 0.3 microns, germanium interface layer 7 has a thickness of 5 to 10 nm and molybdenum germanide layer 6 has a thickness of 0.10 microns. The resulting ohmic contact has a contact resistance of $10^{-6}$ ohm $cm^2$. This contact resistance is two orders of magnitude better than contacts using similar materials but which do not have a molybdenum germanide as an integral part of the contact structure. The resulting contact is stable, has a very low contact resistance and may be subjected to later high temperature processing steps without affecting its characteristics.

While diffusion has been indicated as the mechanism whereby germanium doped gallium arsenide region 5 is formed, it should be appreciated that techniques such as ion implantation may alternatively be used. Thus, germanium may be implanted in substrate 2 deeply enough to dope it with a peak doping at the germanium/ arsenide interface. Any resulting damage can then be annealed to reform an undamaged gallium arsenide substrate 2.

While gallium arsenide has been shown to be the preferred substrate material and silicon the preferred n-type substrate dopant, it should be appreciated that other n-type dopants such as sulphur, tellurium, selenium and tin may also be used. Also, substrates of ternary compounds like gallium aluminum arsenide may be utilised with the same n-type dopants. Other III—V compounds like indium phosphide may be used with the same n-type dopants. In all of the above instances, germanium doped with the Group V element of the substrate or without dopant may be used.

All other III—V compounds are expected to behave in the same manner as gallium arsenide when contacts to them are made as described above. In general, a germanium layer doped with the Group V element of the compound semiconductor may be used together with the germanide forming molybdenum to provide ohmic contacts to substrates having contact resistances which are orders of magnitude lower than those provided when germanide is not formed.

## Claims

1. A process for forming an ohmic contact to a substrate of a semiconductor compound comprising a Group III element and a Group V element and containing an n-type dopant, comprising the steps of vapour depositing germanium and molybdenum onto a surface of the substrate, and heating the substrate in a nonoxidising atmosphere the process being characterised by heating the substrate for seven minutes at a temperature in the range of 725 to 775°C in order to form a layer of molybdenum germanide (MoGe$_2$) and an interface layer not more than 10 nm thick of germanium heavily doped with the Group V element of the semiconductor compound.

2. A process as claimed in Claim 1, in which the germanium and the molybdenum are deposited on the surface of the substrate sequentially.

3. A process as claimed in Claim 1, in which the germanium and the molybdenum are deposited on the surface of the substrate simultaneously.

4. A process as claimed in any preceding claim, in which the deposited germanium is doped with arsenic.

5. A process as claimed in any preceding claim, in which the deposited germanium is amorphous.

6. A process as claimed in any preceding claim, in which the substrate is of gallium arsenide.

7. A semiconductor device including a substrate of an n-type conductivity semiconductor compound comprising a Group III element and a Group V element and having an ohmic contact comprising a region of the substrate doped with germanium and a layer of molybdenum germanide, the device being characterised by the contact having a resistance of $10^{-6}$ ohm cm$^2$ and by the presence of an interface region not more than 10 nm thick, of germanium heavily doped with the Group V element of said Group III—V compound disposed between the region doped with germanium and the molybdenum germanide layer.

8. A semiconductor device as claimed in claim 7, in which the semiconductor compound is gallium arsenide and the n-type dopant is silicon.

9. A semiconductor device as claimed in claim 7, in which the Group V element is arsenic.

10. A semiconductor device as claimed in any of claims 7 to 9, in which the n-type dopant is present in the substrate in a concentration of about $1 \times 10^{17}$ atoms cm$^{-3}$.

11. A semiconductor device as claimed in any of claims 7 to 10, in which the interface region of heavily doped germanium is 5 to 10 nm thick.

12. A semiconductor device as claimed in any of claims 7 to 11, in which arsenic is present in the interface region of heavily doped germanium in a concentration of about $5 \times 10^{19}$ atoms cm$^{-3}$.

## Patentansprüche

1. Verfahren zum Herstellen eines ohm'schen Kontaktes an einem Substrat eines Halbleiters, mit Elementen der Gruppe III und der Gruppe V und mit einer Dotierungssubstanz vom n-Typ enthaltend die Verfahrensschritte Aufdampfen von Germanium und Molybden auf die Oberfläche des Substrates und Erhitzen des Substrates in einer nicht-oxidierenden Atmosphäre, gekennzeichnet durch das Erhitzen des Substrates für sieben Minuten auf eine Temperatur in einem Bereich von 725°C bis 775°C um eine Schicht von Molybdengermanid (MoGe$_2$) und eine Zwischenschicht von nicht mehr als 10 nm Dicke von hochdotiertem Germanium mit dem Element der Gruppe V des Verbundhalbleiters zu bilden.

2. Verfahren nach Anspruch 1, bei welchem das Germanium und das Molybden auf der Oberfläche des Substrates aufeinanderfolgend niedergeschlagen werden.

3. Verfahren nach Anspruch 1, bei welchem das Germanium und das Molybden auf der Oberfläche des Substrates gleichzeitig niedergeschlagen werden.

4. Verfahren nach einem der vorhergehenden Ansprüche, bei dem das niedergeschlagene Germanium mit Arsen dotiert ist.

5. Verfahren nach einem der vorhergehenden Ansprüche, bei welchem das niedergeschlagene Germanium amorph ist.

6. Verfahren nach einem der vorhergehenden Ansprüche, bei welchem das Substrat aus Galliumarsenid besteht.

7. Halbleiterbandelement, mit einem Substrat eines n-leitenden Halbleiters, bestehend aus Elementen der Gruppe III und V und mit einem ohm'schen Kontakt bestehend aus einem Bereich des mit Germanium dotierten Substrates und einer Schicht von Molybdengermanid, dadurch gekennzeichnet, daß der Kontakt einen Wiederstand von $10^{-6}$ Ohm cm$^2$ aufweist und daß ein Zwischenschichtsbereich von nicht mehr als 10 nm Dicke aus mit einem Element der Gruppe V aus der Gruppe III—V hochdatiertem Geranium, das zwischen dem mit Germanium dotierten Bereich und der Molybdengermanidschicht angeordnet ist.

8. Halbleiterbandelement nach Anspruch 7, bei dem Halbleiter aus Galliumarsenid und die Dotierung vom n-Typ Silikon ist.

9. Halbleiter nach Anspruch 7, bei dem das Element der Gruppe V Arsen ist.

10. Halbleitereinrichtung nach einem der Ansprüche 7 bis 9, bei dem die Dotierung vom n-Typ vorgesehen ist in dem Substrat in einer Konzentration von etwa $1 \times 10^{17}$ Atomen cm$^{-3}$.

11. Halbleitereinrichtung nach einem der Ansprüche 7 bis 10, bei dem der Interfacebereich aus hochdotiertem Germanium eine Dicke von 5—10 nm aufweist.

12. Halbleitereinrichtung nach einem der Ansprüche 7 bis 11, bei dem Arsen in dem Interfacebereich von hochdotiertem Germanium vorgesehen ist in einer Konzentration von etwa $5 \times 10^{19}$ Atomen cm$^{-3}$.

## Revendications

1. Procédé de formation d'un contact ohmique sur un substrat d'un composé semiconducteur comprenant un élément du groupe III et un élément du groupe V et contenant un dopant de type N, comprenant les étapes de dépôt en phase vapeur de germanium et de molybdène sur une surface du substrat, et de chauffage du substrat dans une atmosphère non-oxydante, le procédé étant caractérisé par un chauffage du substrat pendant sept minutes à une température dans la gamme de 725 à 775°C dans le but de former une couche de germaniure de molybdène (MoGe$_2$) et une couche d'interface d'une épaisseur non supérieure à 10 nm de germanium fortement dopé par l'élément du groupe V du composé semiconducteur.

2. Procédé selon la revendication 1, dans lequel le germanium et le molybdène sont déposés sur la surface du substrat de façon séquentielle.

3. Procédé selon la revendication 1, dans lequel le germanium et le molybdène sont déposés sur la surface du substrat simultanément.

4. Procédé selon l'une quelconque des revendications précédentes, dans lequel le germanium déposé est dopé à l'arsenic.

5. Procédé selon l'une quelconque des revendications précédentes, dans lequel le germanium déposé est amorphe.

6. Procédé selon l'une quelconque des revendications précédentes dans lequel le substrat est en arséniure de gallium.

7. Dispositif semiconducteur comprenant un composé semiconducteur de conductivité de type N comprenant un élément du groupe III et un élément du groupe V et ayant un contact ohmique comprenant une région du substrat dopée au germanium et une couche de germaniure de molybdène, le dispositif étant caractérisé par le fait que le contact a une résistance de $10^{-6}$ ohm $\cdot$ cm$^2$ et par la présence d'une région d'interface d'une épaisseur non supérieure à 10 nm de germanium fortement dopé par l'élément du groupe V dudit composé du groupe III—V disposée entre la région dopée au germanium et la couche de germaniure de molybdène.

8. Dispositif semiconducteur selon la revendication 7, dans lequel le composé semiconducteur est de l'arséniure de gallium et le dopant de type N est du silicium.

9. Dispositif semiconducteur selon la revendication 7, dans lequel l'élément du groupe V est de l'arsenic.

10. Dispositif semiconducteur selon l'une quelconque des revendications 7 à 9, dans lequel le dopant de type N est présent dans le substrat avec une concentration d'environ $1\times10^{17}$ atomes $\cdot$ cm$^{-3}$.

11. Dispositif semiconducteur selon l'une quelconque des revendications 7 à 10, dans lequel la région d'interface en germanium fortement dopé a une épaisseur de 5 à 10 nm.

12. Dispositif semiconducteur selon l'une quelconque des revendications 7 à 11, dans lequel de l'arsenic est présent dans la région d'interface en germanium fortement dopé avec une concentration d'environ $5\times10^{19}$ atomes $\cdot$ cm$^{-3}$.

## FIG. 1

## FIG. 2

ARSENIC DOPED
Ge INTERFACE 7